Europäisches Patentamt

European Patent Office

Office européen des brevets

(11) Publication number: **0 111 535**
**B1**

(12) **EUROPEAN PATENT SPECIFICATION**

(45) Date of publication of patent specification: **22.08.90**

(51) Int. Cl.⁵: **H 03 L 7/00, H 03 D 3/18**

(21) Application number: **83902052.6**

(22) Date of filing: **18.05.83**

(86) International application number:
**PCT/US83/00753**

(87) International publication number:
**WO 84/00089 05.01.84 Gazette 84/01**

(54) METHOD OF RECOVERING TIMING SIGNALS.

(30) Priority: **14.06.82 US 388026**

(43) Date of publication of application:
**27.06.84 Bulletin 84/26**

(45) Publication of the grant of the patent:
**22.08.90 Bulletin 90/34**

(84) Designated Contracting States:
**DE FR NL**

(56) References cited:
**DE-A-3 013 336**
**US-A-3 654 564**
**US-A-3 742 372**
**US-A-3 800 231**

(73) Proprietor: **Western Electric Company,
Incorporated
222 Broadway
New York, NY 10038 (US)**

(72) Inventor: **HENRY, Paul Shala
11 Deer Path
Holmdel, NJ 07733 (US)**

(74) Representative: **Buckley, Christopher Simon
Thirsk et al
AT&T (UK) LTD. AT&T Intellectual Property
Division 5 Mornington Road
Woodford Green, Essex IG8 OTU (GB)**

Courier Press, Leamington Spa, England.

## Description

This invention relates to a method of recovering a timing signal from a digital data signal.

A digital PCM signal comprises a random sequence of binary digits which occur at a regular periodic rate. To detect and regenerate such a signal it is necessary to provide a clock signal that is synchronous with the signal. This clock can be provided through a separate path, or it can be derived from the incoming data stream. The latter is typically accomplished by a process which includes rectifying the data stream and then applying the rectified signal to a phaselocked voltage-controlled oscillator. (See *Phaselock Techniques* by F. M. Gardner, pp. 117—119, published by John Wiley and Sons, Inc., 1966). This is a two-step process which employs a rectifier circuit and a separate phase detector in the oscillator loop. DE—A—3013336 discloses a timing recovery circuit including a differentiator, a pair of diodes forming part of a phase-detector, a low-pass filter, a voltage-controlled oscillator, and a feedback path.

According to this invention there is provided a method of recovering a timing signal as claimed in claim 1.

The invention will now be described with reference to the accompanying drawings, in which:

FIG. 1 shows a typical prior art timing recovery circuit;

FIG. 2 shows a timing recovery circuit embodying the invention;

FIG. 3 shows typical signal waveshapes at different points in the circuit of Fig. 2;

Fig. 4. shows the resulting phase versus oscillator control voltage characteristic for said circuit; and

FIG. 5 shows another embodiment of the invention.

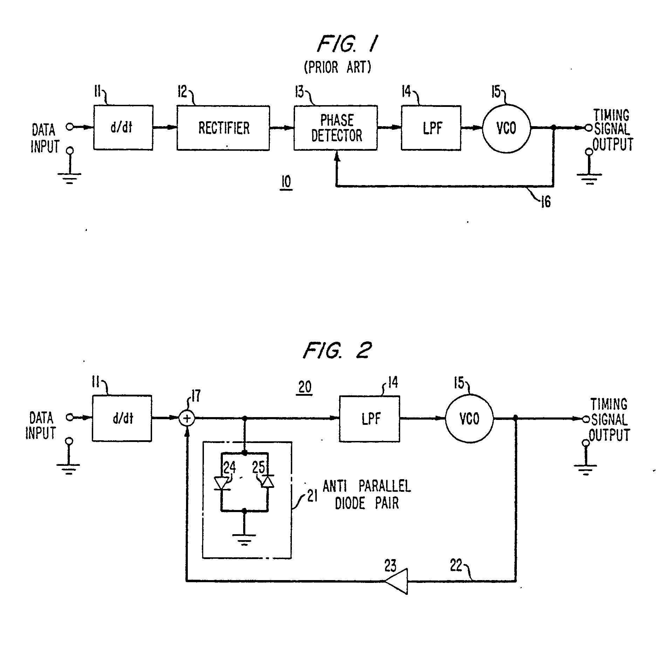

Referring to the drawings, Fig. 1 shows, in block diagram, a prior art timing recovery circuit 10 comprising a separate rectifier and phase detector. More particularly, the circuit comprises, a differentiator 11 (d/dt); a rectifier 12; a phase detector 13; a low-pass filter (LPF) 14; and a voltage-controlled oscillator (VCO) 15. To complete the phase locked loop, the output signal from the VCO, which is the desired timing signal, is fed back by means of signal path 16 to the phase detector 13.

As can be seen in Fig. 1, in the prior art timing circuit shown, rectification and phase detection are separately performed in the respective circuits 12 and 13. In the present invention these functions are performed in a common circuit. Using the same identification numerals to identify corresponding circuit functions, Fig. 2 shows a timing recovery circuit embodying the present invention comprising, in sequence, a differentiator 11 (d/dt); an antiparallel diode pair 21; a low-pass filter 14; and a voltage-controlled oscillator 15. In this timing circuit, the phase locked loop is closed by means of a feedback path 22 which couples the oscillator output signal to a summing circuit 17, located at the output of the differentiator 11. Alternatively, the feedback path can be connected to the input port of the differentiator. A buffer amplifier 23 is advantageously included in feedback path 22 so as to isolate the output timing signal from the differentiated data signal.

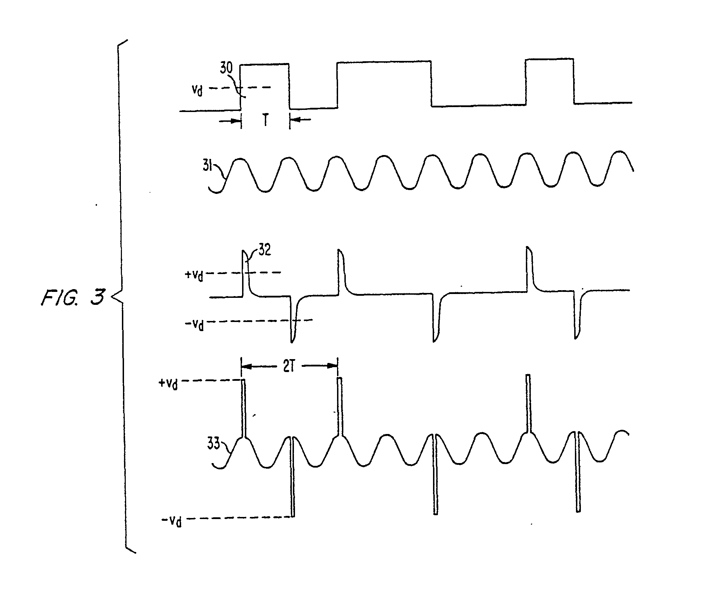

The operation of the timing circuit of Fig. 2 can be readily explained by reference to Fig. 3, which shows voltage waveforms at various points in the timing circuit. These include an arbitrary NRZ input data signal 30 which, for the purposes of this explanation, is assumed to be large compared to the voltage, $v_d$, necessary to drive the diodes 24 and 25 into conduction. Curves 31 and 32 show the oscillator signal and the differentiated data signal at the output of differentiator 11 with the diode pair 21 disconnected. For purposes of this explanation it is further assumed that the amplitude of the oscillator signal is smaller than $v_d$ and that the phase of the oscillator signal is such that the pulses produced at the leading and trailing edges of the data signal pulses coincide with the positive peaks of the oscillator waveform.

Curve 33 shows the resulting waveform obtained when the diode pair is connected.

Because the oscillator signal is smaller than $v_d$, the diodes are open circuits in the presence of the oscillator signal alone. However, in the presence of the combined oscillator and differentiated data signals, one or the other of the oppositely poled diodes is driven into conduction, clamping the voltage across the diode pair at $v_d$.

Because of the assumed phase, it is noted that conduction occurs only during the positive half cycles of the oscillator signal. Furthermore, because the differentiated data pulses occur in pairs of opposite polarity, they generate no average (i.e., d.c.) current. They do, however, reduce the area contained within the positive voltage portion of the combined waveform, resulting in a net negative voltage at the output of the low-pass filter 14.

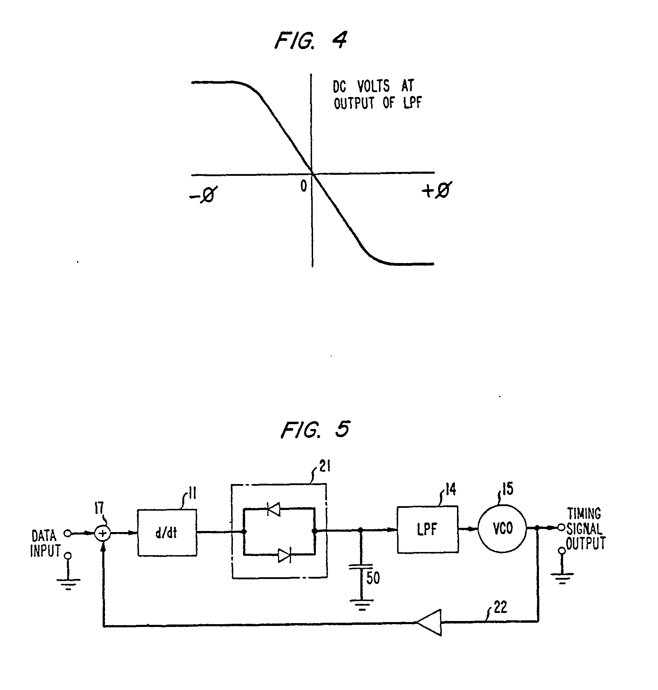

If this analysis is repeated for different relative phases of the oscillator and differentiated data pulses, a phase versus oscillator control voltage characteristic of the type shown in Fig. 4 is obtained, where the relative phase φ is measured between the differentiated data pulses and the zero crossing of the voltage signal. As can be seen, the oscillator will phase lock such that its zero crossings will coincide approximately with the center of the differentiated data pulses.

While an NRZ data stream was conveniently employed to describe the operation of the invention, its operation is not limited to any particular signal format. For example, it will operate just as well with a simple on-off (i.e., RZ) binary signal, a biopolar signal, or a multilevel signal.

In the embodiment of Fig. 2 diode pair 22 is shunt-connected. Fig. 5 shows an alternative embodiment of the invention wherein the diode pair 22 is series-connected. In addition, summing circuit 17 is located at the input of the differentiator 11. A capacitor 50 provides an r.f. return path. In all other respects, the embodiment of Fig. 5 is the same as Fig. 2.

**Claims**

1. A method of recovering a timing signal from a digital data signal, including differentiating (in 11) the data signal, phase-detecting the differentiated signal with the aid of a pair of diodes (24, 25), low-pass filtering (in 14) the phase-detected signal, controlling a voltage-controlled oscillator (15) with the low-pass filtered signal to provide the recovered timing signal, and feeding back output from the oscillator, characterised in that the pair of diodes is antiparallel connected (21) and serves to rectify and phase-detect the differentiated signal, and the fed back output from the oscillator is summed at a point upstream of the diode pair with the signal at that point.

2. A method as claimed in claim 1 wherein said signal at that point is the differentiated signal.

3. A method as claimed in claim 1 wherein said signal at that point is the data signal prior to differentiation.

4. A method as claimed in any preceding claim wherein the amplitude of the differentiated signal applied to the diode pair is greater than the voltage required to cause conduction in the diodes, and the peak amplitude of the fed back output from the oscillator applied to the diode pair is less than the said voltage.

5. A method as claimed in any preceding claim wherein the diode pair is shunt-connected.

6. A method as claimed in any preceding claim wherein the diode pair is series-connected.

**Patentansprüche**

1. Verfahren zur Wiedergewinnung eines Zeitsteuerungssignals aus einem digitalen Datensignal mit den Schritten: Differenzieren (in 11) des Datensignals, Phasen-Detektieren des differenzierten Signals mit Hilfe eines Paares von Dioden (24, 25), Tiefpaßfiltern (in 14) des phasendetektierten Signals, Steuern eines spannungsgesteuerten Oszillators (15) mit dem tiefpaßgefilterten Signal zur Bereitstellung des wiedergewonnenen Zeitsteuerungssignals und Rückkoppeln eines Ausgangssignals des Oszillators, dadurch gekennzeichnet, daß das Paar von Dioden antiparallel geschaltet (21) ist und zur Gleichrichtung und Phasendetektierung des differenzierten Signals dient und daß das rückgekoppelte Ausgangssignal des Oszillators an einem Punkt stromaufwärts vom Diodenpaar mit dem Signal an diesem Punkt summiert wird.

2. Verfahren nach Anspruch 1, bei dem das Signal an dem Punkt das differenzierte Signal ist.

3. Verfahren nach Anspruch 1, bei dem das Amplitude des an das Diodenpaar angelegten differenzierten Signals größer als die Spannung ist, die zu einer Stromleitung in den Dioden erforderlich ist, und daß die Spitzenamplitude des rückgekoppelten Oszillator-Ausgangssignals, das an das Diodenpaar angelegt ist, kleiner als die genannte Spannung ist.

5. Verfahren nach einem der vorhergehenden Ansprüche, bei dem das Diodenpaar parallelgeschaltet ist.

6. Verfahren nach einem der vorhergehenden Ansprüche, bei dem das Diodenpaar in Reihe geschaltet ist.

**Revendications**

1. Un procédé de récupération d'un signal d'horloge à partir d'un signal de données numériques, dans lequel on différentie (en 11) le signal de données, on détecte la phase du signal différentié avec l'aide d'une paire de diodes (24, 25), on applique un filtrage passe-bas (en 14) au signal qui résulte de la détection de phase, on commande un oscillateur commandé par tension (15) avec le signal qui résulte du filtrage passe-bas, pour fournir le signal d'horloge récupéré, et on renvoie en rétroaction le signal de sortie de l'oscillateur, caractérisé en ce que la paire de diodes est connectée en une configuration antiparallèle (21) et elle remplit les fonctions de redressement et de détection de phase pour le signal différentié, et le signal de sortie de l'oscillateur qui est envoyé en rétroaction est sommé en un point situé en amont de la paire de diodes, avec le signal présent en ce point.

2. Un procédé selon la revendication 1, dans lequel le signal en ce point est le signal différentié.

3. Une procédé selon la revendication 1, dans lequel le signal en ce point est le signal de données avant différentiation.

4. Un procédé selon l'une quelconque des revendications précédentes, dans lequel l'amplitude du signal différentié qui est appliqué à la paire de diodes est supérieure à la tension nécessaire pour provoquer la conduction des diodes, et l'amplitude de crête du signal de sortie de rétroaction provenant de l'oscillateur qui est appliqué à la paire de diodes est inférieure à la tension précitée.

5. Un procédé selon l'une quelconque des revendications précédentes, dans lequel la paire de diodes est connectée en dérivation.

6. Un procédé selon l'une quelconque des revendications précédentes, dans lequel la paire de diodes est connectée en série.

EP 0 111 535 B1

FIG. 1
(PRIOR ART)

FIG. 2

1

FIG. 3

*FIG. 4*

*FIG. 5*